# EUROPÄISCHE PATENTSCHRIFT

(11) **EP 0 947 006 B1**
(45) Veröffentlichungstag und Bekanntmachung des Hinweises auf die Patenterteilung: **03.09.2003**
(21) Anmeldenummer: 97948860.8
(22) Anmeldetag: 03.11.1997
(51) Int. Cl.: H01L 51/30, H01L 31/09, G01J 1/42

(54) **STRAHLUNGSDETEKTOR**
RADIATION DETECTOR
DETECTEUR DE RAYONNEMENT

(30) Priorität: 11.11.1996 DE 19646411
(43) Veröffentlichungstag der Anmeldung: 06.10.1999
(73) Patentinhaber: Covion Organic Semiconductors GmbH, 65926 Frankfurt (DE)
(72) Erfinder: SALBECK, Josef, D-65779 Kelkheim (DE); GRÄTZEL, Michael, CH-1015 St.-Sulpice (CH)
(74) Vertreter: Luderschmidt, Schüler & Partner GbR
(86) Internationale Anmeldenummer: EP9706050
(87) Internationale Veröffentlichungsnummer: WO98021764

(56) Entgegenhaltungen:
- EP-A- 0 676 461
- DE-A- 2 725 955

## Beschreibung

Die Erfindung bezieht sich auf einen optoelektrischen Detektor zur Ermittlung des Auftretens und der Wellenlänge von kurzwelliger elektromagnetischer Strahlung.

Solche Detektoren kommen vorzugsweise dort zum Einsatz, wo das Auftreten und die Wellenlänge kurzwelliger elektromagnetischer Strahlung, insbesondere von UV- und Röntgenstrahlung, ermittelt werden soll, wobei die UV-Strahlung vorzugsweise im Bereich zwischen 190 und 450 nm, besonders bevorzugt zwischen 200 und 420 nm, ganz besonders bevorzugt zwischen 250 und 400 nm liegt.

Es ist bekannt, daß solche Strahlung gesundheitsschädlich ist. Insbesondere kann die Bestrahlung der Haut oder der Augen mit Licht solcher Wellenlänge Hautkrebs oder Blindheit hervorrufen. Die Gefahr einer solchen photochemisch induzierten malignen Entartung der Haut ist durch die vermehrten Anteile von UV-A und UV-B Strahlung im natürlichen Sonnenicht in den letzten Jahren stark angestiegen. Was die Exposition der Augen gegen UV-Licht anbelangt, so hat sich durch die Vielzahl der Lichtquellen (Kathodenstrahlröhren, Schweißgeräte, Hochtemperaturöfen, Computerbildschirm, Fernseher etc.), denen der Mensch beruflich und privat ausgesetzt ist, auch hier das Risiko erheblich erhöht.

Es besteht daher die Notwendigkeit, Detektoren zu entwickeln, welche die Präsenz solcher schädlicher Strahlung in verläßlicher, effizienter und selektiver Weise erlauben.

In der DE-A 43 06 407 ist ein Detektor zur Überprüfung des Wellenlängenbereichs von elektromagnetischer Strahlung beschrieben, der eine photoaktive Schicht aufweist, die aus Titandioxid mit einer hohen Porosität gefertigt ist. In die photoaktive Schicht sind ein flüssiger Elektrolyt als Ladungstransportmedium und ein Farbstoff eingebettet, wobei der Farbstoff so gewählt ist, daß er von elektromagnetischer Strahlung einer definierten Wellenlänge angeregt werden kann.

Die Verwendung einer Elektrolytflüssigkeit ist jedoch grundsätzlich von Nachteil, da sie Probleme, beispielsweise mit der Dichtigkeit der Zelle und Photokorrosion, mit sich bringt.

Der Erfindung liegt deshalb die Aufgabe zugrunde, einen Detektor bereitzustellen, mit dem das Auftreten und die Wellenlänge von kurzwelliger elektromagnetischer Strahlung auf einfache Weise und zudem exakt bestimmt werden kann.

Es wurde nun überraschend gefunden, daß sich optoelektronische Strahlendetektoren auch mit einem Lochleitermaterial als Ladungstransportschicht herstellen lassen.

Ein Gegenstand der Erfindung ist daher ein optoelektronischer Strahlungsdetektor, gekennzeichnet durch eine Ladungstransportschicht, die ein Lochleitermaterial enthält.

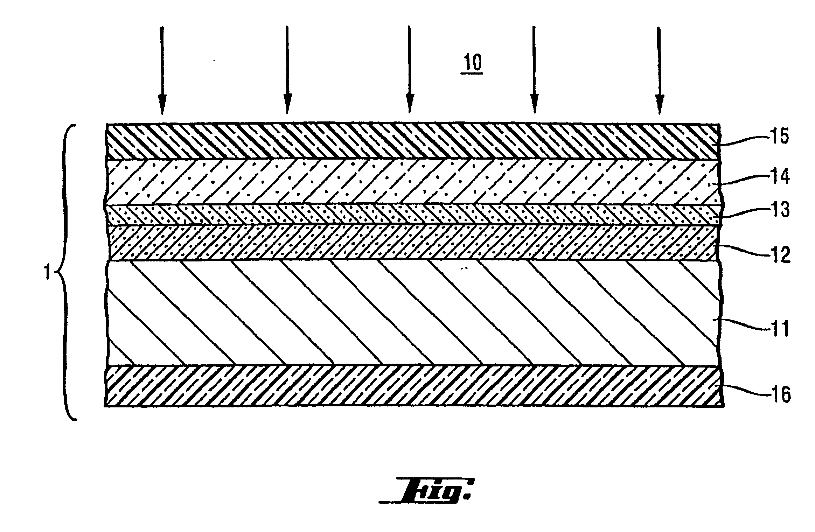

Mangels Elektrolyt treten bei dem erfindungsgemäßen Detektor beispielsweise keine Probleme mit der Photokorrosion auf.
Der erfindungsgemäße Detektor zeigt eine breite Empfindlichkeit. Durch die gezielte Verwendung bestimmter Lochleiter läßt sich das selektive Aktionsspektrum einfach steuern. Eine zusätzliche Farbstoffschicht ist in der Regel nicht notwendig.
In der Figur ist eine bevorzugte Ausführungsform des erfindungsgemäßen Detektors 1 dargestellt (nicht maßstabsgetreu).
Auf einem leitenden Träger 11, der als Elektrode bzw. Kontakt dient und beispielsweise aus einem Metall oder Metalloxid, wie fluordotiertem Zinndioxid oder Indium-Zinn-Oxid (ITO), besteht, ist als absorbierende Schicht ein Halbleiter 12 aufgebracht, der vorzugsweise eine Oberfläche mit einem Rauheitsfaktor > 1 aufweist. Daran schließt sich ein Ladungstransportschicht 13 an, die erfindungsgemäß ein Lochleitermaterial enthält. Sie wird auf der einen Seite durch die Gegenelektrode 14 begrenzt, die beispielsweise aus einem leitfähigen Glas, leitfähig beschichtetem Kunststoff, aus Metall, einem transparenten leitendem Oxid (TCO) oder einem anderen leitfähigen, vorzugsweise strahlungsdurchlässigem Material, bestehen kann. Der Detektor 1 kann oben und unten durch je eine isolierende Schicht 15 bzw. 17 abgeschlossen sein (Verkapselung). Er kann einen, in der Figur nicht gezeigten seitlichen Abschluß enthalten, beispielsweise einen Rahmen aus einem elektrisch isolierendem Material, wie Kunststoff oder Glas. Zumindest eine Seite des Detektors muß für die zu detektierende kurzwellige elektromagnetische Strahlung 10 durchlässig sein, so daß diese zu dem Halbleiter gelangen kann. Der erfindungsgemäße Detektor enthält darüber hinaus in der Figur nicht gezeigte Vorrichtungen zur Messung der auftretenden Spannungen, Ströme oder Leitfähigkeitsänderungen, wobei die Messung der beiden letztgenannten Größen bevorzugt ist.

Als Lochleitermaterial im Sinne der Erfindung gilt ein Material, das eine positive Ladung, die durch das Fehlen eines Elektrons zustande kommt, leiten kann, wobei Massentransport und Ladungstransport entkoppelt sind.

Allgemein eignen sich elektronenreiche, vorzugsweise organische Verbindungen, die, vorzugsweise reversibel, oxidierbar sind. Es wird allgemein angenommen, daß der Ladungstransport in einem organischen Lochleitermaterial über die Bildung von Radikalkationen erfolgt.

Das Oxidationspotential ist dabei in weiten Bereichen variabel und kann, beispielsweise durch Auswahl geeigneter Strukturen, an die spezifischen Energieniveaus des Halbleiters oder Sensibilisators angepaßt werden. Es liegt vorzugsweise über dem Energieniveau des Grundzustandes des Valenzbandes des Halbleiters und unterhalb des Energieniveaus des niedrigsten Leitungsbandes und damit in der Regel im Bereich der Bandbreite des Halbleiters (vorzugsweise 100 - 500 mV oberhalb des Energieniveaus des Grundzustands). Bevorzugt sind Lochleitermaterialien, bei denen kein Massentransport stattfindet, bzw. bei denen Ladungs- und Massentransport völlig entkoppelt sind.
Weiterhin bevorzugt sind feste, insbesondere amorphe Lochleitermaterialien.

Ein Gegenstand der Erfindung ist daher auch die Verwendung fester amorpher Lochleitermaterialien zur Herstellung von Ladungstransportschichten für optoelektronische Strahlungsdetektoren zur Detektion kurzwelliger elektromagnetischer Strahlung.

Dabei ist es im Sinne der Erfindung bevorzugt, daß die erfindungsgemäße Lochleiterschicht amorph präparierbar ist, d.h. im amorphen Zustand in dem erfindungsgemäßen Detektor aufgebracht wird.

Der Begriff "amorph" dient zur Zustandsbeschreibung von Festkörpern, deren molekulare Bausteine nicht in Kristallgittern, sondern regellos angeordnet sind. Anders als in einem Kristall, bei dem zwischen den Atomen eine Nahordnung (d.h. konstante Abstände zu nächsten Nachbaratomen) und eine Fernordnung (regelmäßiges Wiederholen eines Basisgitters) existiert, liegt im amorphen Zustand nur eine Nahordnung vor. Der amorphe Stoff besitzt keine physikalisch ausgezeichnete Richtung; er ist isotrop. Alle amorphen Stoffe streben unterschiedlich stark den energetisch günstigeren kristallinen Zustand an. Bei Beugung von Röntgen-, Elektronen- und Neutronenstrahlen zeigen sich beim amorphen Festkörper keine scharfen Interferenz-Ringe, wie bei einem Kristall, sondern nur diffuse Interferenzringe bei kleinen Beugungswinkeln (Halos).

Der amorphe Zustand ist somit klar vom kristallinen, flüssigen oder auch flüssigkristallinen Zustand unterschieden.

Besonders bevorzugt sind Lochleitermaterialien, die in organischen Lösungsmitteln löslich sind, sowie Lochleitermaterialien, die schmelzbar oder verdampfbar sind. Beispiele für organische Lösungsmittel sind Chloroform, Benzol, Chlorbenzol, Cyclohexanon, Toluol, Tetrahydrofuran, Anisol, Cresol, Xylol, Methyllaktat, Methylenchlorid, Hexan, oder andere aliphatische, aromatische oder alkoholische Lösungsmittel. Es ist vorteilhaft für die Herstellung einer erfindungsgemäßen Lochleiterschicht, wenn das Lochleitermaterial in einem organischen Lösungsmittel löslich ist oder schmelzbar ist. Löslich im Sinne der Erfindung bedeutet dabei eine Löslichkeit von mindestens 1,0 g/l bei 25°C in einem organischen oder anorganischen Lösungsmitel, vorzugsweise in einem der oben aufgeführten Lösungsmittel.

Weiterhin besonders bevorzugt sind Lochleitermaterialien, die anhand ihrer Größe in die Poren einer rauhen Halbleiterschicht eindiffundieren können.

Ganz besonders bevorzugt sind bei Messung eines Photostroms Lochleitermaterialien, bei denen der Spannungsverlust über die Lochleiterschicht bei Bestrahlung mit kurzwelliger elektromagnetischer Strahlung <500 mV, vorzugsweise <50 mV, besonders bevorzugt < 20 mV beträgt.
Die Lochleiterschicht weist im allgemeinen eine Dicke von 0,1 bis 20, vorzugsweise 1 bis 15 µm auf.
Die Ladungsträgerbeweglichkeit des Lochleitermaterials beträgt vorzugsweise mindestens 10⁻⁵ cm²/Vs, insbesondere 10⁻³ bis 10 cm²/Vs.

Ganz besonders bevorzugt als Lochleitermaterialien sind Spiro- und Heterospiroverbindungen der Formel (I), 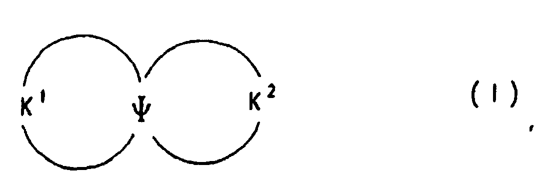 wobei
Ψ C, Si, Ge oder Sn, vorzugsweise C, Si oder Ge, besonders bevorzugt C oder Si und insbesondere C und
K¹ und K² unabhängig voneinander konjugierte Systeme bedeuten.

Spiroverbindungen sind Verbindungen in denen zwei Ringsysteme durch ein einziges, vierbindiges Atom verknüpft sind. Dieses Atom wird als Spiroatom bezeichnet, wie in Handbook of Chemistry and Physics 62^{nd} ed. (1981-2), CRC Press, S. C-23 bis C-25 ausgeführt ist. Der Begriff Spiroverbindung bedeutet im Sinne der Erfindung monomere und polymere Carbospiro- und Heterospiroverbindungen.

Bevorzugte Verbindungen der Formel (I) sind 9,9'-Spirobifluorenderivate der Formel (II), 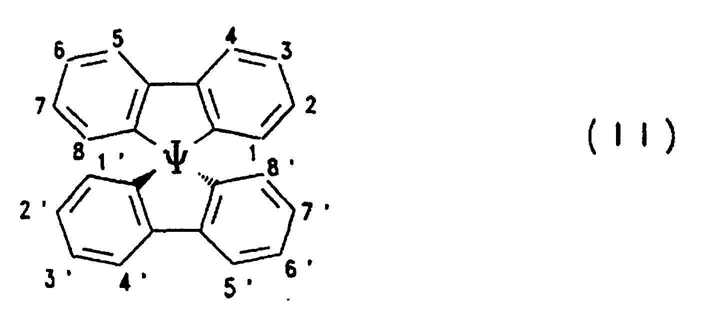 wobei Ψ die oben angegebenen Bedeutungen hat und wobei die Benzogruppen unabhängig voneinander substituiert und/oder anelliert sein können.

Besonders bevorzugt sind Spirobifluorenderivate der Formel (III), 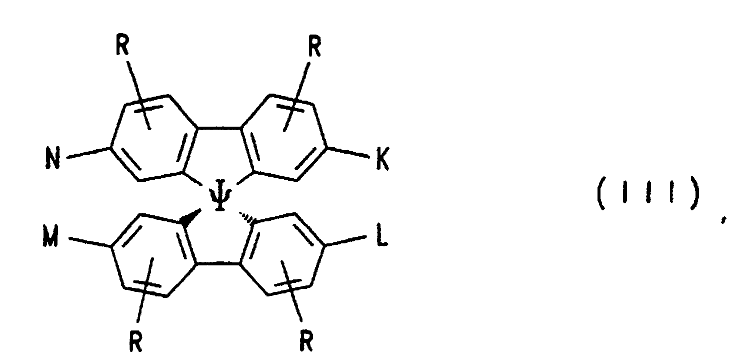 wobei die Symbole und Indizes folgende Bedeutungen haben:
Ψ ist C, Si, Ge oder Sn, vorzugsweise C, Si, Ge, besonders bevorzugt C, Si, insbesondere C,
K, L, M, N sind gleich oder verschieden und bedeuten eine Gruppe der Formeln

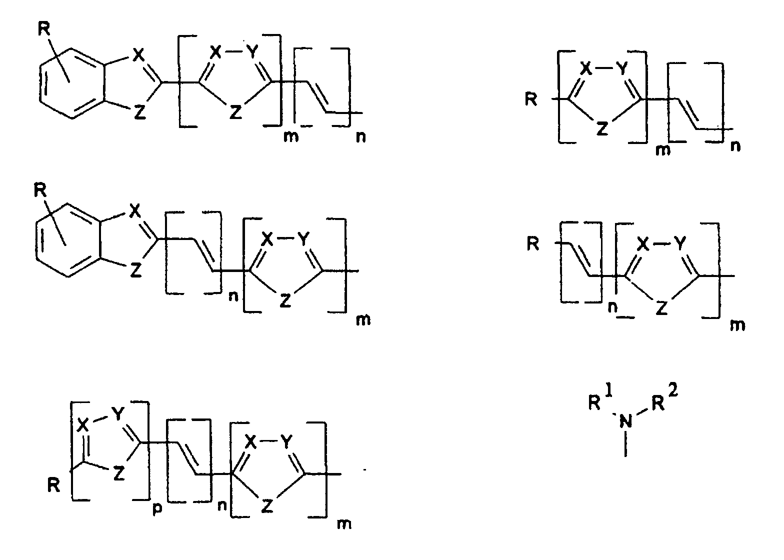

- R: hat, gleich oder verschieden, die gleichen Bedeutungen wie K, L, M, N oder ist Wasserstoff, eine lineare oder verzweigte Alkyl-, Alkoxy- oder Carboalkoxygruppe mit 1 bis 22, vorzugsweise 1 bis 15, besonders bevorzugt 1 bis 12 C-Atomen, -CN, -NO₂, -NR¹R², -Ar oder -O-Ar;
- Ar: ist Phenyl, Biphenyl, 1-Naphthyl, 2-Naphthyl, 2-Thienyl, 2-Furanyl, wobei jede dieser Gruppen einen oder zwei Reste R tragen kann;
- m, n, p: sind 0, 1, 2 oder 3;
- X, Y: sind =CR- oder = N-;
- Z: ist -O-, -S-, -NR-, -CRR-, -CH = CH-, -CH = N-;
- R¹ und R²: sind Wasserstoff, eine lineare oder verzweigte Aikylgruppe mit 1 bis 22 C-Atomen, -Ar oder 3-Methylphenyl.

Bevorzugte Verbindungen der Formel (III) sind solche der Formel (IIIa)-(IIIg)

### IIIa) K = L = M = N und ist eine Gruppe der Formeln:

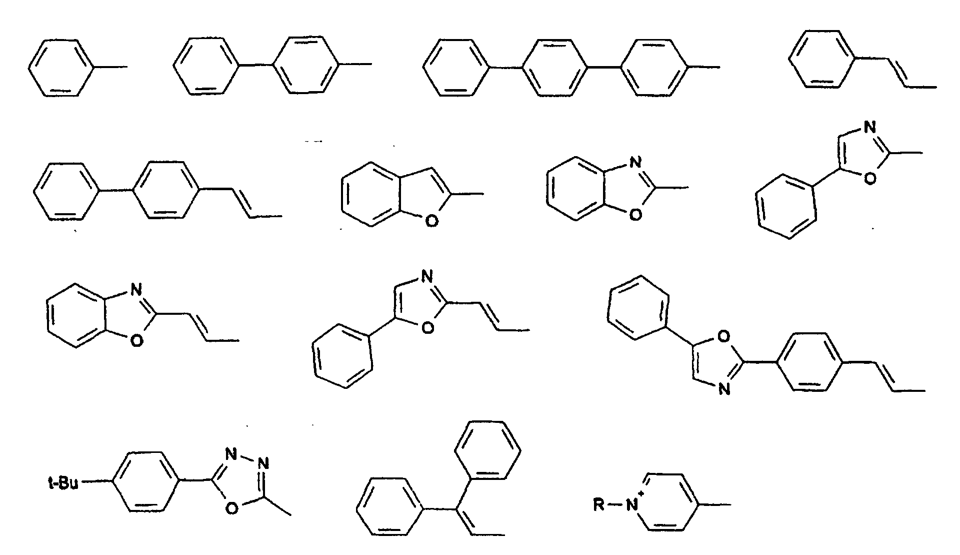

R = C₁-C₂₂-Alkyl, C₂H₄SO₃-

### IIIb) K = M = H und N = L und ist eine Gruppe der Formeln:

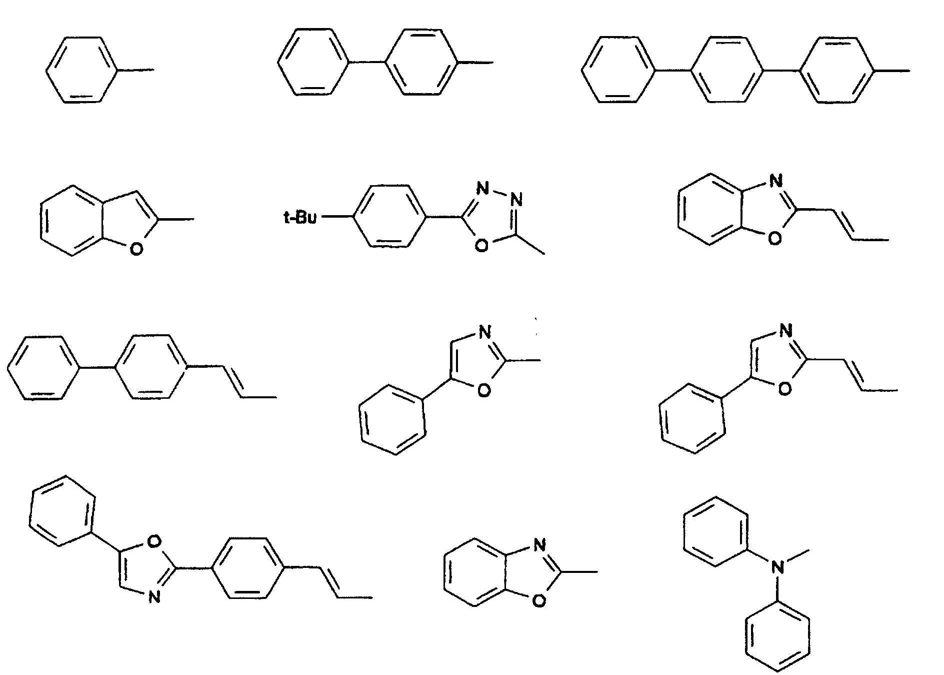

### IIIc) K = M und ist eine Gruppe der Formeln:

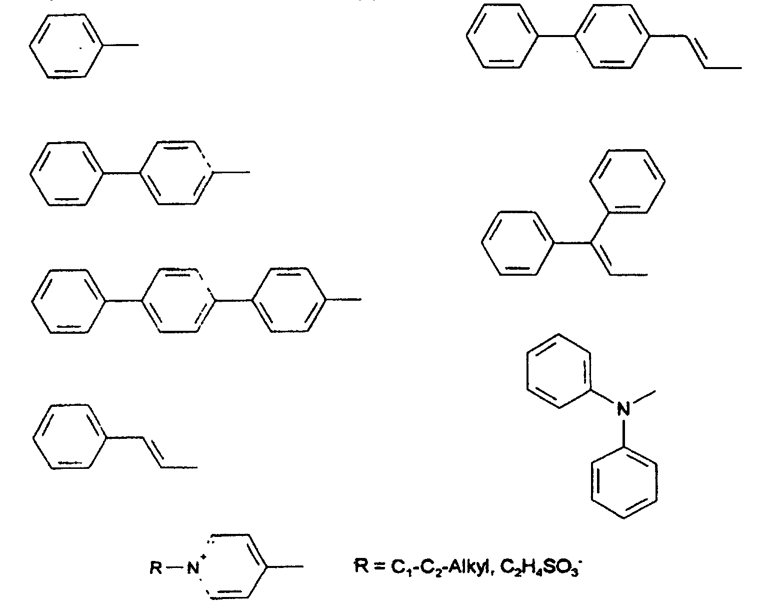

und N = L und ist eine Gruppe der Formeln:

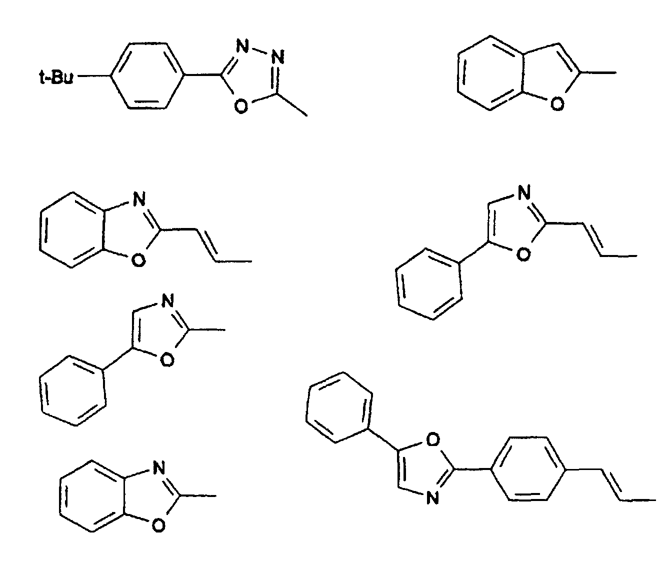

### IIId) K = M und ist eine Gruppe der Formeln:

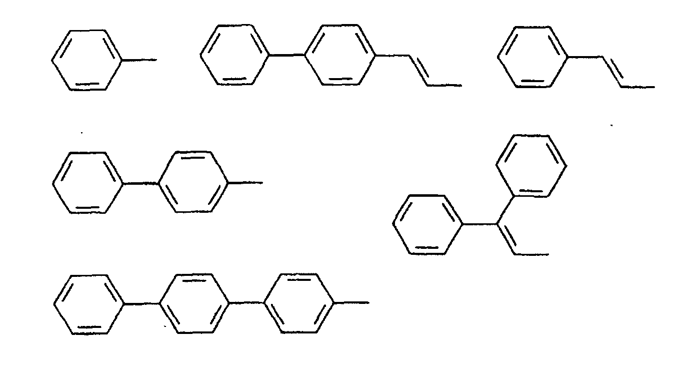

und N = L und ist eine Gruppe der Formeln:

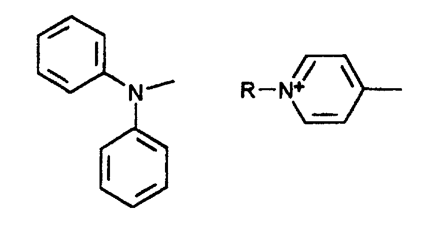

R = C₁-C₂₂-Alkyl, C₂H₄SO₃⁻

### IIIe) K = L = H und M = N und ist eine Gruppe der Formeln:

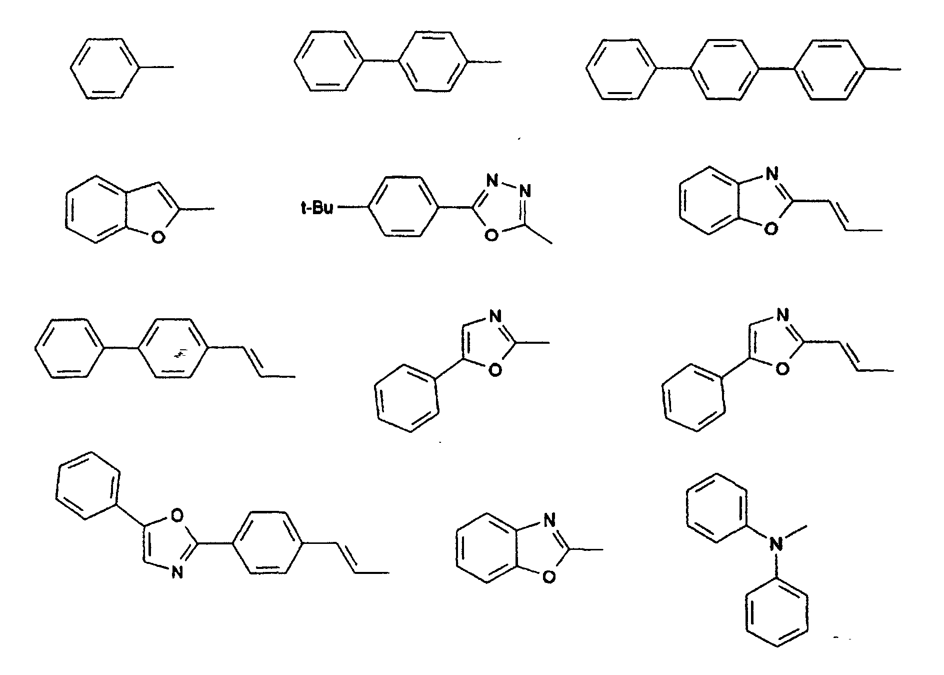

### IIIf) K = L und ist eine Gruppe der Formeln:

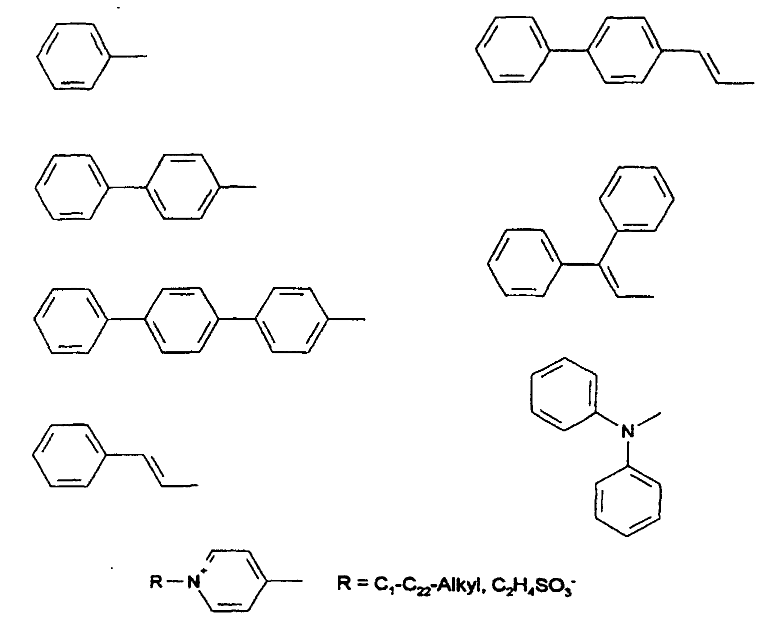

und M = N und ist eine Gruppe der Formeln:

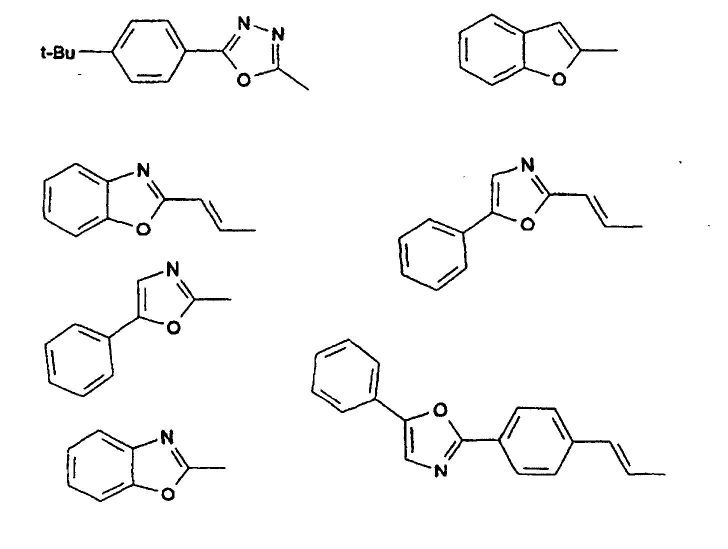

### IIIg) K = L und ist aus der Gruppe:

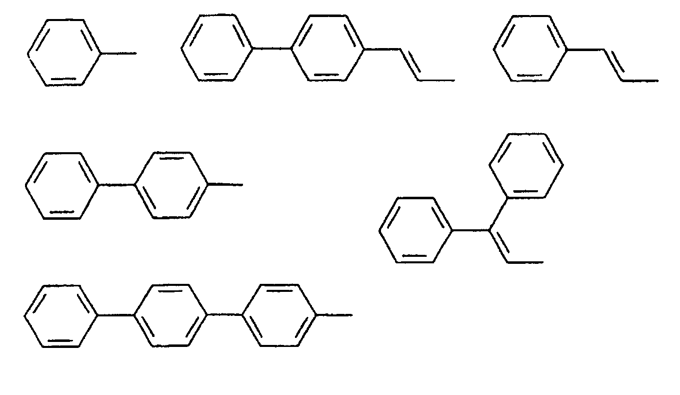

und M = N und ist eine Gruppe der Formeln:

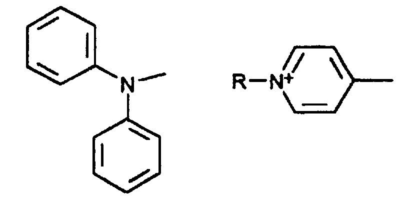

R = C₁-C₂₂-Alkyl, C₂H₄SO₃⁻

Besonders bevorzugte Verbindungen der Formel (III) sind solche der Formeln (IIIaa) bis (IIIdb):

### (IIIaa) K = L = M = N und ist eine Gruppe der Formeln:

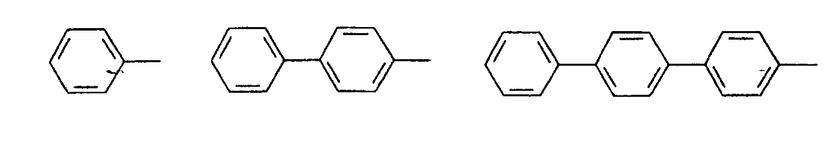

### (IIIba) K = M = H und N = L und ist eine Gruppe der Formeln:

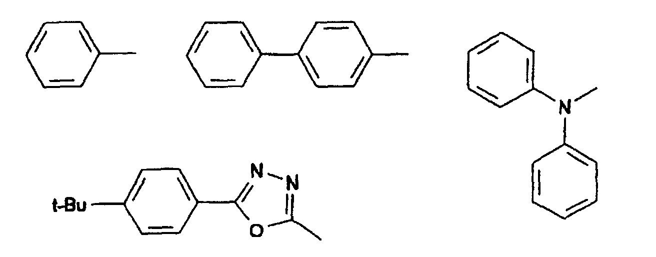

### (IIIca) K = M und ist eine Gruppe der Formeln:

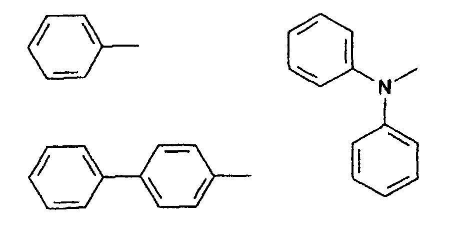

und N = L und ist:

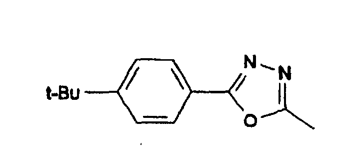

### (IIIda) K = M und ist eine Gruppe der Formeln:

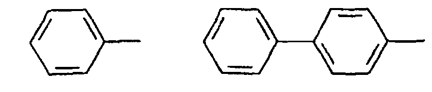

und N = L und ist:

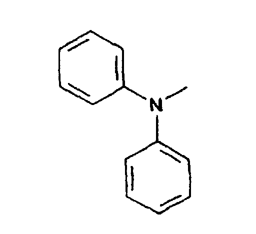

### (IIIab) K = L = M = N und ist eine Gruppe der Formeln:

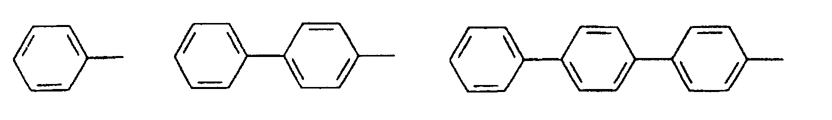

### (IIIbb) K = L = H und M = N und ist eine Gruppe der Formeln:

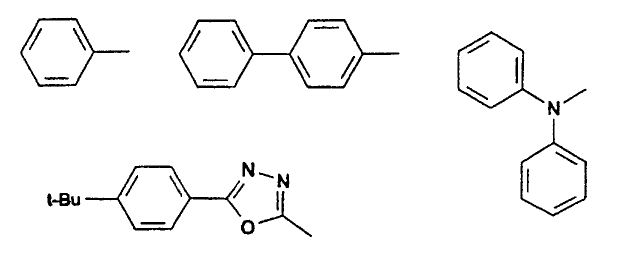

### (IIIcb) K = L und ist eine Gruppe der Formeln:

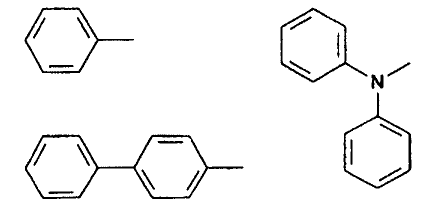

und M = N und ist:

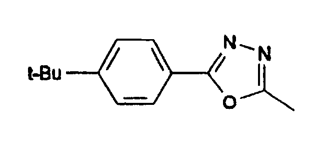

### (IIIdb) K = L und ist eine Gruppe der Formeln:

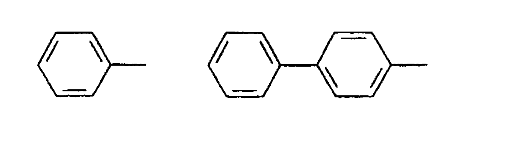

und M = N und ist:

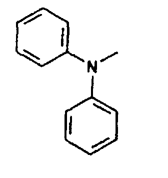

Ganz besonders bevorzugte Spiroverbindungen sind solche der Formel (IV), 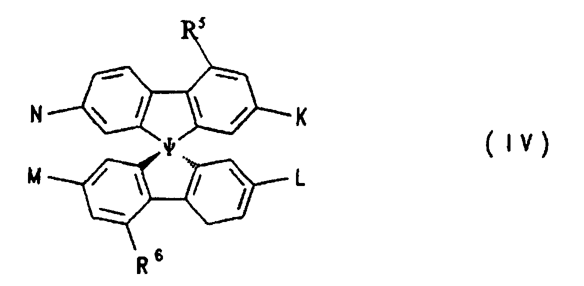 wobei die Symbole folgende Bedeutungen haben:
Ψ ist C oder Si, vorzugsweise C;
K, L, M und N sind gleich oder verschieden eine der Gruppen G1 bis G14:

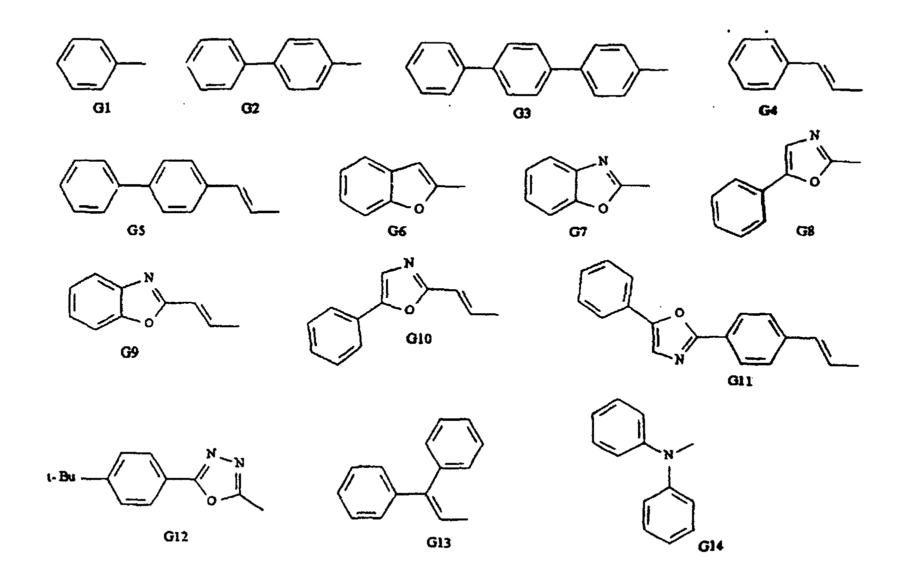

- und R⁵, R⁶: können auch gleich oder verschieden Wasserstoff oder eine lineare oder verzweigte Alkyl-, Alkyloxy- oder Estergruppe mit 1 bis 22 C-Atomen, -CN oder -NO₂ bedeuten.

Insbesondere bevorzugte Spiroverbindungen der Formel (IV) sind
2,2',4,4',7,7'-Hexakis(biphenylyl)-9,9'-spirobifluoren,
2,2',4,4',7,7'-Hexakis(terphenylyl)-9,9 '-spirobifluoren,
2,2 ',4,4'-Hexakis(biphenylyl)-9,9'-spirobi-9-silafluoren und
2,2 ',4,4',7,7'-Hexakis(terphenylyl)-9,9'-spirobi-9-silafluoren.

Die Herstellung der erfindungsgemäß verwendeten Spiro- und Heterospiroverbindungen erfolgt nach an sich bekannten Methoden, wie sie in der EP-A 0 676 461 und Standardwerken zur Organischen Synthese, z.B. Houben-Weyl, Methoden der Organischen Chemie, Georg-Thieme-Verlag, Stuttgart und in den entsprechenden Bänden der Serie "The Chemistry of Heterocyclic Compounds" von A. Weissberger und E. C. Taylor (Herausgeber) beschrieben werden.

Die Herstellung erfolgt dabei unter Reaktionsbedingungen, die für die genannten Umsetzungen bekannt und geeignet sind. Dabei kann auch von an sich bekannten, hier nicht näher erwähnten Varianten Gebrauch gemacht werden.

### a) Carbospiroverbindungen

Verbindungen der Formel (III) werden beispielsweise ausgehend vom 9,9'-Spirobifluoren erhalten, dessen Synthese z.B. von R. G. Clarkson, M. Gomberg, J. Am. Chem. Soc. 1930, 52, 2881, beschrieben ist.

Die Herstellung von Verbindungen der Formel (IIIa) kann beispielsweise ausgehend von einer Tetrahalogenierung in den Positionen 2,2',7,7' des 9,9'-spirobifluorens und anschließender Substitutionsreaktion erfolgen (siehe z.B. US 5,026,894) oder über eine Tetraacetylierung der Positionen 2,2',7,7' des 9,9'-Spirobifluorens mit anschließender C-C-Verknüpfung nach Umwandlung der Acetylgruppen in Aldehydgruppen oder Heterocyclenaufbau nach Umwandlung der Acetylgruppen in Carbonsäuregruppen erfolgen.

Die Herstellung von Verbindungen der Formel (IIIb) kann beispielsweise analog zu denen der Formel IIIa erfolgen, wobei die stöchiometrischen Verhältnisse bei der Umsetzung so gewählt werden, daß die Positionen 2,2' bzw. 7,7' funktionalisiert werden (siehe z.B. J. H. Weisburger, E. K. Weisburger, F. E. Ray, J. Am. Chem. Soc. 1959, 72 4253; F. K. Sutcliffe, H. M. Shahidi, D. Paterson, J. Soc. Dyers Colour 1978, 94, 306 und G. Haas, V. Prelog, Helv. Chim. Acta 1969, 52 1202).

Die Herstellung von Verbindungen der Formel (IIIc) kann beispielsweise über eine Dibromierung in 2,2'Stellung und anschließender Diacetylierung in 7,7' Stellung des 9,9'-Spirobifluorens und anschließende Umsetzung analog zu der der Verbindungen (IIIa) erfolgen.

Verbindungen der Formeln (IIIe)-(IIIg) sind beispielsweise durch Wahl geeignet substituierter Ausgangsverbindungen beim Aufbau des Spirobifluorens herstellbar, z.B. kann 2,7-Dibromspirobifluoren aus 2,7-Dibromfluorenon und 2,7-Dicarbethoxy-9,9'-spirobifluoren durch Einsatz von 2,7-Dicarbethoxyfluorenon aufgebaut werden. Die freien 2',7'-Positionen des Spirobifluorens können dann unabhängig weiter substituiert werden.

Für die Synthese der Gruppen K, L, M, N, sei beispielsweise verwiesen auf DE-A 23 44 732, 24 50 088, 24 29 093, 25 02 904, 26 36 684, 27 01 591 und 27 52 975 für Verbindungen mit 1,4-Phenylen-Gruppen;
DE-A 26 41 724 für Verbindungen mit Pyrimidin-2,5-diyl-Gruppen;
DE-A 40 26 223 und EP-A 03 91 203 für Verbindungen mit Pyridin-2,5-diyl-Gruppen;
DE-A 32 31 462 für Verbindungen mit Pyridazin-3,6-diyl-Gruppen; N. Miyaura, T. Yanagi und A. Suzuki in Synthetic Communications 1981, 11, 513 bis 519, DE-A-39 30 663; M. J. Sharp, W. Cheng, V. Snieckus, Tetrahedron Letters 1987, 28, 5093; G. W. Gray, J. Chem. Soc. Perkin Trans II 1989, 2041 und Mol. Cryst. Liq. Cryst. 1989, 172, 165; Mol. Cryst. Liq. Cryst. 1991, 204, 43 und 91; EP-A 0 449 015; WO 89/12039; WO 89/03821; EP-A 0 354 434 für die direkte Verknüpfung von Aromaten und Heteroaromaten.

Die Herstellung disubstituierter Pyridine, disubstituierter Pyrazine, disubstituierter Pyrimidine und disubstituierter Pyridazine findet sich beispielsweise in den entsprechenden Bänden der Serie "The Chemistry of Heterocyclic Compounds" von A. Weissberger und E. C. Taylor (Herausgeber).

### b) Heterospiroverbindungen

Solche Verbindungen der Formel (III) werden beispielsweise ausgehend vom Bis-[biphenyl-2,2'-diyl]silan (=9,9'-Spirobi(9H-)-silafluoren) (V) erhalten, dessen Synthese z.B. von H. Gilman, R. D. Gorsich, J. Am. Chem. Soc. 1958, 80, 3243, beschrieben ist.

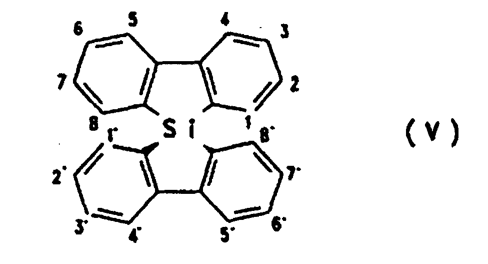

Die Herstellung von Heterospiroverbindungen der Formel (IIIa) kann beispielsweise ausgehend von einer Tetrahalogenierung in den Positionen 2,2',7,7' des 9,9'-Spirobi-9-silafluorens und anschließender
Substitutionsreaktion erfolgen, die von analogen C-Spiroverbindungen bekannt (siehe z.B. US 5,026,894) oder über eine Tetraacetylierung der Positionen 2,2',7,7' des 9,9'-Spirobi-9-silafluorens mit anschließender C-C-Verknüpfung nach Umwandlung der Acetylgruppen in Aldehydgruppen oder Heterocyclenaufbau nach Umwandlung der Acetylgruppen in Carbonsäuregruppen erfolgen.
Die Herstellung von Verbindungen der Formel (IIIb) kann beispielsweise analog zu denen der Formel (IIIa) erfolgen, wobei die stöchiometrischen Verhältnisse bei der Umsetzung so gewählt werden, daß die Positionen 2,2' bzw. 7,7' funktionalisiert werden (siehe z.B. J. H. Weisburger, E. K. Weisburger, F. E. Ray, J. Am. Chem. Soc. 1959, *72,* 4253; F. K. Sutcliffe, H. M. Shahidi, D. Paterson, J. Soc. Dyers Colour 1978, 94, 306 und G. Haas, V. Prelog, Helv. Chim. Acta 1969, 52, 1202).

Die Herstellung von Verbindungen der Formel (IIIc) kann beispielsweise über eine Dibromierung in 2,2'-Stellung mit anschließender Diacetylierung in 7,7'-Stellung des 9,9'-Spirobi-9-silafluorens und anschließender Umsetzung analog zu der der Verbindungen (IIIa) erfolgen.

Verbindungen der Formel (IIIe)-(IIIg) sind beispielsweise herstellbar durch Wahl geeignet substituierter Ausgangsverbindungen beim Aufbau des Spirosilabifluorens entsprechend den beiden folgenden Reaktionsschemata:

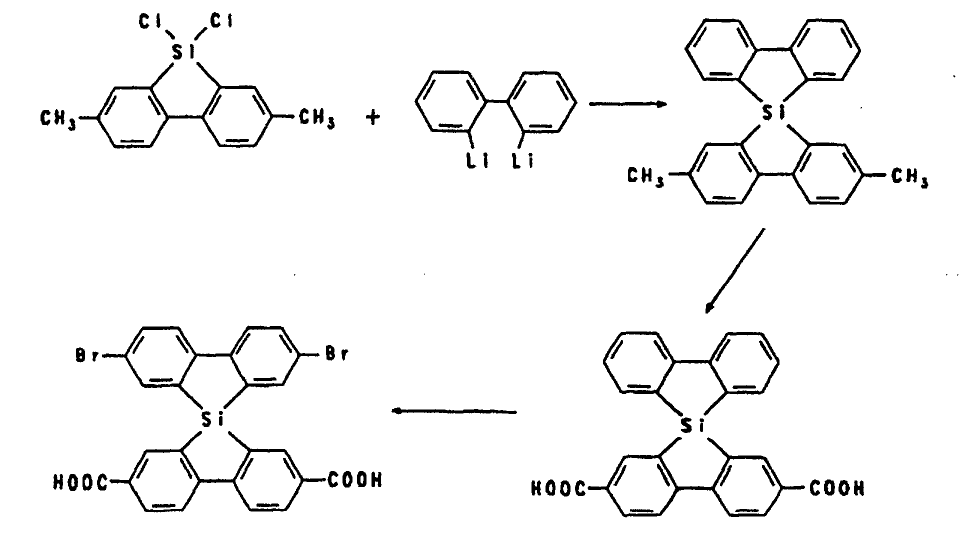

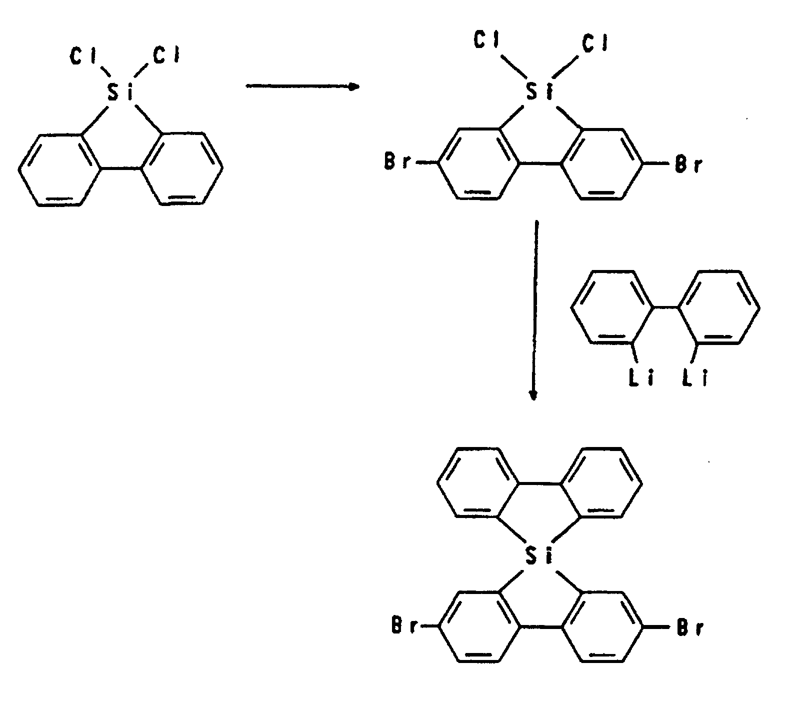

Darüber hinaus sind die dem Fachmann geläufigen Synthesesequenzen wie Nitrierung, Reduzierung, Diazotierung und Sandmeyer-Reaktion einzusetzen. Für die Synthese der Gruppen K, L, M, Q sei auf die entsprechenden Carbospiroverbindungen verwiesen.

Grundsätzlich ist es auch möglich, Oligo- oder Polymere mit den entsprechenden Spiroeinheiten einzusetzen, wobei bei Verwendung eines nanokristallinen Halbleiters beachtet werden muß, daß die Verbindungen in der Lage sind, in die Poren des nanokristallinen Halbleiters einzudringen. Solche Verbindungen sind in der EP-A 0 707 020; WO-A 96/17 036;
DE-A 196 06 511; DE-A 196 14 971 und DE-A 196 15 128 beschrieben; auf diese Schriften wird hiermit ausdrücklich Bezug genommen, ihre Offenbarung gilt durch Zitat als Bestandteil der vorliegenden Anmeldung.

Der erfindungsgemäße Detektor enthält als lichtabsorbierende Schicht vorzugsweise einen Halbleiter, der vorzugsweise eine sehr große Bandlücke, besonders bevorzugt mindestens 3,0 eV, ganz besonders bevorzugt über 3,0 eV, aufweist.
Damit eignen sich vorzugsweise Metalloxid-Halbleiter, insbesondere die Oxide der Übergangsmetalle, sowie der Elemente der dritten Hauptgruppe und der vierten, fünften und sechsten Nebengruppe (des periodischen Systems der Elemente) von Titan, Zirkon, Hafnium, Strontium, Zink, Indium, Yttrium, Lanthan, Vanadium, Niob, Tantal, Chrom, Molybdän, Wolfram, aber auch Oxide von Zinn, Eisen, Nickel oder Silber, Perovskite wie SrTiO₃, CaTiO₃, oder Oxide von anderen Metallen der zweiten und dritten Hauptgruppe oder Mischoxide oder Oxidgemische dieser Metalle. Es kann aber auch jedes andere Metalloxid mit Halbleitereigenschaften und großem Energieabstand (Bandlücke) zwischen Valenzband und Leitungband verwendet werden.
Besonders bevorzugt als Halbleitermaterial sind Titandioxid, Nb₂O₅ und ZnO, ganz besonders bevorzugt ist Titandioxid.

Der Halbleiter weist vorzugsweise einen Rauheitsfaktor von größer als 1, besonders bevorzugt von größer als 20, ganz besonders von größer als 150 auf.
Der Rauheitsfaktor ist definiert als das Verhältnis einer wirklichen/effektiven Oberfläche zur Fläche der Projektion dieser Oberfläche eines Körpers, in diesem Fall also der Oberfläche des Halbleiters.

Der Rauheitsfaktor kann z.B.
durch gravimetrische Adsorptionsmethoden bestimmt werden, wie z.B. in F. Kohlrausch, Praktische Physik, Band 1, S. 397 (Stuttgart: B.G. Teubner, 1985) beschrieben wird. Im allgemeinen beträgt die Größe der Poren 5-200 nm, vorzugsweise 10-50 nm.

Ein Verfahren zum Herstellen von polykristallinen Metalloxyd-Halbleiterschichten mit dem SOL-GEL-Verfahren (beschrieben in Einzelheiten z. B. in Stalder und Augustynski, J. Electrochem. Soc. 1979, 126, 2007), wo beim Verfahrensschritt der Hydrolyse des Metall-Alkoholats die prozentuale relative Feuchtigkeit der Umgebungsatmosphäre in einem Bereich von 30 % bis 80 % liegen kann und innerhalb von ± 5 %, vorzugsweise ± 1 %, konstant gehalten wird, ergibt Metalloxid-Halbleiterschichten, mit denen in erfindungsgemäßen photovoltaischen Zellen eine besonders hohe elektrische Ausbeute erzielt werden kann.

Durch die Rauhigkeit wird die Kontaktfläche zwischen Halbleiter und Ladungstransportschicht erhöht und gleichzeitig die Weglänge, die vom Minoritätsladungsträger zurückgelegt werden muß, um zur Ladungstransportschicht zu gelangen, herabgesetzt, wodurch sich die Quantenausbeute erhöht.

Als Beispiel für die Herstellung einer Titanoxydschicht (TiO₂) mit hohem Rauheitsfaktor auf einem Titansubstrat, wird nachfolgend das SOL-GEL-Verfahren beispielhaft beschrieben.
Das Titansubstrat aus reinem Titanium von etwa 99,5 % Reinheit wird zuerst während etwa 30 Minuten in etwa 18 %iger kochender HCl gereinigt. Die Titan-Ethoxyd-Lösung kann z. B. durch die Lösung von 21 mMol TiCl₄ in 10 ml sehr reinem Ethanol (puriss.) erhalten werden. Diese Lösung wird dann mit sehr reinem Methanol (puriss.) verdünnt, um eine Titankonzentration im Bereich von etwa 25 bis 50 mg/ml zu erhalten. Auf das Titansubstrat gibt man einen Tropfen der Lösung und das Titan-Alkoxyd wird bei Raumtemperatur während ca. 30 Minuten bei einer Feuchtigkeit von 48 ± 1 % hydrolysiert. Danach wird das Substrat mit der hydrolysierten Schicht während ca. 15 Minuten auf ca. 450°C erhitzt. Dieser Prozeß wird mehrmals wiederholt. Nach 10- bis 15-maliger Wiederholung hat die TiO₂-Schicht eine Dicke von etwa 20 µm erreicht. Danach wird das Substrat mit der Schicht bei etwa 500°C während etwa 30 Minuten in einer Rein-Argon-Atmosphäre (z. B. 99,997 %) ausgeheizt. Die so hergestellte TiO₂-Schicht hat einen Rauheitsfaktor im Bereich von 200.

Derartige Metalloxid-Halbleiter-Schichten (auch anderer Metalle) können nach analogen Verfahren auf anderen Substraten erzeugt werden. Die oberen Schichten des Halbleiters können gegebenenfalls, wie z. B. in der WO-A 91/16719 beschrieben, mit einem divalenten oder trivalenten Metall dotiert sein.

Als, vorzugsweise verschiedene, Materialien für Elektrode 11 und Gegenelektrode 15 eignen sich stabile, metallisch leitende Substanzen, z. B. Au, Ag, Pt, Cu, oder andere Metalle. Es können aber auch für einige Anwendungen vorzugsweise lichtdurchlässige leitfähige Substanzen, wie dotierte Metalloxide, z. B. Indium-Zinn-Oxid, Sb-dotiertes Zinnoxid, F-dotiertes Zinnoxid oder Aldotiertes Zinkoxid, verwendet werden. Dabei kann die Austrittsarbeit des verwendeten Elektrodenmaterials vorzugsweise an das lonisationspotential des verwendeten Lochtransportmaterials angepaßt werden.

Die Elektrode kann, wie in der EP-A 0 333 641 beschrieben, auf ein transparentes Substat, z. B. Glas aufgebracht werden, und mit der Lochtransportschicht verbunden sein. Vorzugsweise kann sie in der in dieser Erfindung beschriebenen Zelle durch physikalische Abscheidemethoden, z. B. Aufdampfen oder Zerstäuben (Sputtern) direkt auf die Lochtransportschicht aufgebracht werden, ohne daß eine zweite Glasplatte notwendig ist. Dieses Verfahren ist zu bevorzugen, wenn das Gewicht der Zelle vermindert werden soll.

Gegebenenfalls kann die Elektrode zwischen Elektrode 11 und der Halbleiterschicht 12, wie in der WO-A 93/19479 beschrieben, mit einem weiteren Halbleiter beschichtet sein. Dies ist bevorzugt, falls die Halbleiterschicht 12 einen Rauhigkeitsfaktor > > 1 aufweist, um eine direkte Ladungsübertragung von der Lochleiterschicht 13 zur Elektrode 11 zu vermeiden.

Als elektrisch isolierende Materialien 16 und 17 bzw. gegebenenfalls als seitlicher Rahmen für die erfindungsgemäße Zelle eignen sich beispielsweise Kunststoff oder Glas.

Gegenstand der Erfindung ist daher auch ein Verfahren zur Herstellung eines Strahlungsdetektor, dadurch gekennzeichnet, daß man auf einem leitfähigen festen Träger
a) eine Halbleiterschicht, vorzugsweise in nanokristalliner Form, beispielsweise durch CVD, aufbringt,
b) darauf eine Transportschicht, enthaltend ein Lochleitermaterial, aufbringt,
c) darauf die Gegenelektrode aufbringt und auf diese gegebenenfalls
d) eine isolierende Schicht aufbringt.

Mit Vorteil kann der Detektor, z. B. mit einem Kleber oder einer Folie, versiegelt werden.

Der erfindungsgemäße elektrooptische Detektor hat im allgemeinen eine Dicke aus dem Bereich von 0,1 bis 20 mm (mit Substrat).

Zur Erhöhung der Strahlungsausbeute bei Detektion von UV-Strahlung kann die Rückseite der Zelle so konstruiert sein, daß die Strahlung diffus in den Detektor zurückreflektiert wird.

Die Detektion erfolgt in bekannter, dem Fachmann geläufigen Weise im allgemeinen durch Messung des (Photo-)Stroms, der Leitfähigkeitsänderung oder der Spannung. Bevorzugt ist die Messung des Stroms oder der Leitfähigkeitsänderung.

Die Strommessung kann durch ein Galvanometer (im nA bis A-Bereich) erfolgen, beispielsweise durch ein Minigalvanometer mit LCD-Anzeige.
Zur Messung der Leitfähigkeitsänderung kann ein Galvanometer in Kombination mit einer externen Spannungsquelle verwendet werden.

Die Messung der Spannung kann durch ein Voltmeter erfolgen.
Allgemein sind diese Detektionsmethoden beispielsweise in John Moore, Christopher Davis and Michael Coplan, Building Scientific Apparatus, S. 257-264, Adison-Wesley, London, 1983, beschrieben.

Die Erfindung wird durch die Beispiele näher erläutert.

### Synthesebeispiele

### Beispiel 1

### 9,9'-Spirobifluoren

7,66 g Magnesiumspäne und 50 mg Anthracen wurden in 100 ml trockenem. Diethylether in einem 1l Dreihalskoben mit Rückflußkühler unter Argon vorgelegt und mit 75 g 2-Brombiphenyl gelöst in 60 ml trockenem Diethylether umgesetzt. Anschließend wurden 56,77 g 9-Fluorenon gelöst in 500 ml trockenem Diethylether unter Rühren zugetropft. Nach beendeter Zugabe wurde 2 Stunden weiter gekocht. Der ausgefallene gelbe Magnesiumkomplex wurde abgesaugt und mit Ether gewaschen. Der abfiltrierte gelbe Magnesiumkomplex wurde dann in einer Lösung aus 48 g Ammoniumchlorid in 800 ml Eiswasser hydrolysiert. Nach 60 min. Rühren wurde das gebildete Fluorenol abgesaugt, mit Wasser gewaschen, und trockengesaugt. Das getrocknete Produkt wurde dann in ca. 800 ml Eisessig unter Zugabe von 3 ml HCI conc. 2 h am Rückfluß gekocht. Nach Abkühlung wurde das Produkt abgesaugt, mit Wasser gewaschen und getrocknet. Zur weiteren Reinigung wurde einmal aus Aceton umkristallisiert. Man erhielt 86 g 9,9'-Spirobifluoren als farblose Kristalle (82 % Ausbeute).

### Beispiel 2

### Synthese von 2,2',4,4',7,7'-Hexabromo-9,9'-spirobifluoren

Zu einer Lösung von 3,16 g (10 mmol) 9,9'-Spirobifluoren in 20 ml Methylenchlorid wurden 200 mg wasserfreies FeCl₃ gegeben und mit Ultraschall behandelt. Der Reaktionskolben wurde mit Al-Folie vor Lichtzutritt geschützt. Anschließend wurden in der Siedehitze 9,85 g (3.15 ml, 62 mmol) Brom in 5 ml Methylenchlorid innerhalb von 15 min zugetropft. Die Lösung wurde weitere 20 h am Rückfluß gekocht und mit Ultraschall behandelt. Nach Abkühlung wurde Petrolether versetzt und abgesaugt. Zur weiteren Reinigung wurde aus THF / Methanol umkristallisiert und 5 h bei 80°C getrocknet. Ausbeute 6,15 g (77 %) farblose Kristalle.

### Beispiel 3

### Synthese von 2,2',4,4',7,7'-Hexabiphenylyl-9, 9'-spirobifluoren (Verbindung 1)

In einem 250 ml Zweihalskolben mit Rückflußkühler, KPG-Rührer wurden 1,6 g Hexabromspirobifluoren und 3 g Biphenylboronsäure in einer Mischung aus 50 ml Toluol und 50 ml 1 M Kaliumcarbonatlösung aufgeschlämmt. Die Mischung wurde unter Stickstoff zum Rückfluß erhitzt und 115 mg Tetrakis-(triphenylphosphin)palladium in 5 ml Toluol zugegeben. Anschließend wurde unter Rühren weitere 7 h am Rückfluß gekocht. Nach Beendigung der Reaktion wurde die abgekühlte Lösung abfiltriert und das Filtrat 2 x mit Wasser ausgeschüttelt (zur besseren Phasentrennung wurde Chloroform zugesetzt). Die organische Phase wurde über Natriumsulfat getrocknet, über eine kurze Säule mit Kieselgel filtriert und anschließend das Lösungsmittel am Rotationsdampfer abgezogen. Zur weiteren Reinigung wurde aus Dichlormethan / Pentan umkristallisiert. Man erhielt 2 g (80 %) farblose, unter UV-Beleuchtung blau fluoreszierende Kristalle.

### Beispiel 4

### 2,2',7,7'-Tetrajod-9,9'-spirobifluoren

In einem 100 ml Zweihalskolben mit Rückflußkühler und Trockenrohr wurden 3,16 g (10 mmol) 9,9'-Spirobifluoren, gelöst in 30 ml Chloroform, bei Raumtemperatur mit 5,8 g (22.8 mmol) lod versetzt und anschließend 10,75g (25 mmol) Bis-(trifluoracetoxy)-iodbenzol zugegeben. Das Reaktionsgemisch erwärmte sich auf ca 40°, unter Bildung eines hellen Niederschlags. Nach 1,5 h wurde das bereits ausgefallene Produkt abgesaugt, und mit Chloroform nachgewaschen und getrocknet. Die Chloroformlösungen werden vereinigt, und nacheinander mit gesättigter Natriumsulfitlösung, gesättigter Natriumcarbonatlösung und Wasser gewaschen. Nach dem Trocknen über Natriumsulfat wurde eingeengt und eine zweite Produktfraktion erhalten. Beide Produktfraktionen wurden vereinigt, in Aceton aufgekocht und nach Abkühlung abgesaugt. Man erhielt 2,2',7,7'-Tetrajod-9,9'-spirobifluoren als feinkristallines farbloses Pulver mit 8,1 g in nahezu quantitativer Ausbeute.
¹H-NMR (CDCl₃, ppm): 6.98 (d, J = 1,48 Hz, 4 H, H-1,1',8,8'); 7.54 (dd, J = 7.88, 1.48 Hz, 4 H, H-3,3',6,6'); 7.72 (d, J = 7.88 Hz, 4 H, H-4,4',5,5').

### Beispiel 5

### 2,2',7,7'-Tetrakis(diphenylamino)-9,9'-spiroblfluoren (Verbindung 2)

2,1 g (2,56 mmol) Tetraiodspirobifluoren wurden mit 2,25 g (13,3 mmol) Diphenylamin unter Zusatz von 2,76 g (20 mmol) Kaliumcarbonat, 635 mg (10 mmol) Kupferpulver und 208 mg (0,79 mmol) 18 - Krone-6 in 10 ml o-Dichlorbenzol unter Stickstoff 48 h zum Sieden erhitzt. Nach Abkühlung wurden die anorganischen Bestandteile abfiltriert und mit warmem Dichlorbenzol nachgewaschen. Das Dichlorbenzol wurde durch Vakuumdestillation (100 mbar, 135 - 140°C) entfernt. Der Rückstand wurde in Chloroform gelöst, über eine kurze Kieselgelsäule abfiltriert und eingeengt. Zur Reinigung wurde erst aus Chloroform/Aceton und anschließend aus Chloroform/Diethylether unter Zusatz von 2 Tropfen Hydrazinhydrat umkristallisiert. Man isolierte mit 56% Ausbeute 1,4 g 2,2',7,7'-Tetrakis(diphenylamin)-9,9'-spirobifluoren in Form sehr feiner, gelblich-weißer Kristallnadeln.
¹H-NMR (CDCl₃, ppm): 6.69 (d, J = 1,83 Hz, 4 H, H-1,1',8,8'); 6.92 (dd, J = 8.18, 1.99 Hz, 4 H, H-3,3',6,6'); 6.98 (m, 24 H); 7.20 (m, 16 H); 7.45 (d, J = 8.18 Hz, 4 H, H-4,4',5,5').

### Beispiel 6

### N,N,N',N',N",N",N'",N'"-Octakis(4-methoxyphenyl)-9,9'-Spirobifluoren-2,2',7,7'-tetramin

Die zur obigen Vorschrift analoge Umsetzung von Tetraiodspirobifluoren mit 4,4'-Dimethoxydiphenylamin lieferte mit vergleichbarer Ausbeute N,N,N',N',N",N",N"',N"'-Octakis(4-methoxyphenyl)-9,9'-Spirobifluoren-2,2',7,7'-tetramin als gelblich gefärbtes Kristallpulver.
¹H-NMR (CDCl₃, ppm): 3.76 (s, 24 H, OCH₃); 6.54 (d, J = 1,99 Hz, 4 H, H-1,1 ',8,8'); 6.75 (dm, J = 9.07 Hz, 16 H); 6.79 (dd, J = 8.18, 1.99 Hz, 4 H, H-3,3',6,6'); 6.90 (dm, J = 9.07 Hz, 16 H); 7.35 (d, J = 8.18 Hz, 4 H, H-4,4',5,5').

### Anwendungsbeispiele

### Beispiel 7

Die in Beispiel 3 beschriebene Verbindung 1 wurde bei einer Konzentration von 50 g/l in Tetrahydrofuran gelöst. Durch Eintauchen in die Lösung wurde ein Substrat beschichtet, das aus leitfähigem, SnO₂-beschichtetem Glas bestand, auf dem auf einer Seite eine glatte Schicht aus Nb-dotiertem Titandioxid aufgebracht worden war (Substrat I). Durch ein Tauchverfahren wurden beide Seiten des Substrats beschichtet. Auf der mit Titandioxid beschichteten Seite wurde anschließend durch thermisches Aufdampfen eine dünne Schicht aus Gold abgeschieden. Die mit Titandioxid und Gold beschichtete Seite wird im folgenden als die aktive Seite, die andere als die inaktive Seite bezeichnet.

Die so präparierte Probe wurde in einem optischen Aufbau montiert, der aus einer Hochdrucklampe, optischen Filtern, Linsen und Halterungen bestand. Durch den Einsatz von Filtern und das Verschieben der Linsen konnte die Intensität variiert werden. Ferner wurde das Licht mit Wellenlänge unterhalb von 380 nm im wesentlichen ausgefiltert. Die Probe wurde mit der inaktiven Seite zur Lampe gerichtet montiert, so daß das Restlicht im Bereich des Absorptionsspektrums von Verbindung 1 von der sich auf der inaktiven Seite befindenden Schicht absorbiert wurde. Durch die Dotierung mit Nb wies die Titandioxidschicht eine geringe Absorption zwischen 400 und 450 nm auf, so daß diese von der Lampe angeregt wurde.

Die Gold- und SnO₂-Schichten wurden kontaktiert und an ein Strommeßgerät angeschlossen, während die Probe belichtet wurde. Es wurde keine externe Spannung angelegt. Während der Belichtung der Probe wurde ein Strom beobachtet, der nach Abblenden der Lichtquelle wieder verschwand. Die Intensität der Belichtung wurde über einen Faktor zehn variiert; über diesen Bereich wuchs der Photostrom linear mit der Intensität.

### Beispiel 8

Die Verbindung 1 wurde bei einer Konzentration von 50 g/l in Tetrahydrofuran gelöst. Durch Eintauchen in die Lösung wurde ein Substrat beschichtet, das aus leitfähigem, SnO₂-beschichtetem Glas bestand, auf dem auf der einen Seite eine nanoporöse Schicht aus Titandioxid aufgebracht worden war, wobei der Anteil der oberhalb 400 nm noch schwach absorbierenden Rutilphase etwa 30 % betrug und die Oberfläche einen Rauheitsfaktor von 700-1000 aufwies (Substrat II). Durch ein Tauchverfahren wurden beide Seiten des Substrats beschichtet. Auf der mit Titandioxid beschichteten Seite wurde anschließend durch thermisches Aufdampfen eine dünne Schicht aus Gold aufgebracht. Die mit Titandioxid und Gold beschichtete Seite wird im folgenden als die aktive Seite, die andere als die inaktive Seite bezeichnet.

Die so präparierte Probe wurde in dem in Beispiel 7 beschriebenen optischen Aufbau montiert. Die Probe wurde mit der inaktiven Seite zur Lampe gerichtet montiert, so daß das Restlicht im Bereich des Absorptionsspektrums von Verbindung 1 von der sich auf der inaktiven Seite befindenen Schicht absorbiert wurde. Durch den Anteil an der Rutilphase wies die Titandioxidschicht eine geringe Absorption zwischen 400 und 430 nm auf, so daß diese von der Lampe angeregt wurde.

Die Gold- und SnO₂-Schichten wurden kontaktiert und an einem Strommeßgerät angeschlossen, während die Probe belichtet wurde. Es wurde keine externe Spannung angelegt. Während der Belichtung der Probe wurde ein Strom beobachtet, der nach Abblenden der Lichtquelle wieder verschwand. Die Intensität der Belichtung wurde über einen Faktor zehn variiert; über diesen Bereich wuchs der Photostrom linear mit der Intensität. Der Photostrom war um ein Vielfaches höher als der Photostrom der im Beispiel 7 beschriebenen Probe.

## Patentansprüche

1. Optoelektronischer Strahlungsdetektor zur Detektion kurzwelliger elektromagnetischer Strahlung aufweisend eine Ladungstransportschicht, die ein Lochleitermaterial enthält, **dadurch gekennzeichnet, daß** als Lochleitermaterial eine oder mehrere Spiroverbindung der Formel (I) 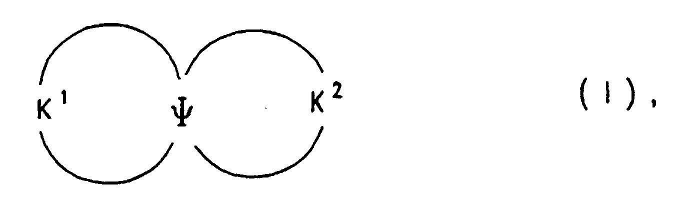 wobei
ψ C, Si, Ge oder Sn, vorzugsweise C, Si, Ge, besonders bevorzugt C, Si und insbesondere C, und
K¹ und K² unabhängig voneinander konjugierte Systeme bedeuten, verwendet werden.

2. Detektor nach Anspruch 1, **dadurch gekennzeichnet, daß** als Lochleitermaterial ein oder mehrere 9,9'-Spirobifluorenderivate der Formel (II) 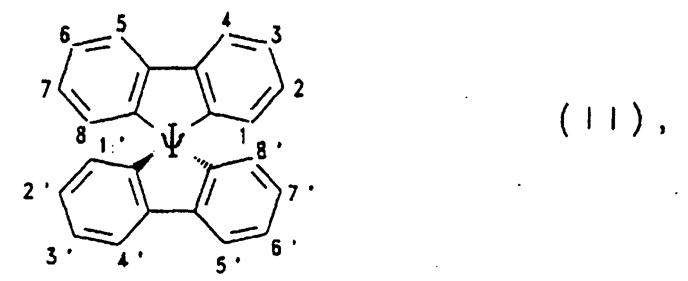 wobei Ψ in Formel (II) in Anspruch 1 angegebenen Bedeutungen hat und die Benzogruppen unabhängig voneinander substituiert und/oder anelliert sein können, verwendet werden.

3. Detektor nach Anspruch 2, **dadurch gekennzeichnet, daß** als Lochleitermaterial ein oder mehrere Spirobifluorenderivate der Formel (III), 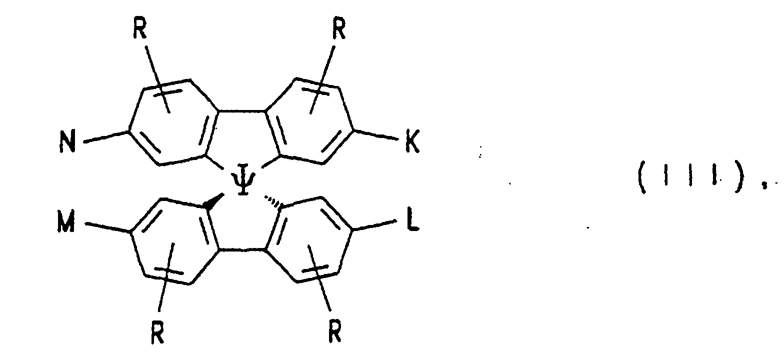 wobei die Symbole und Indizes folgende Bedeutungen haben:
ψ ist C, Si, vorzugsweise C,
K, L, M, N sind gleich oder verschieden 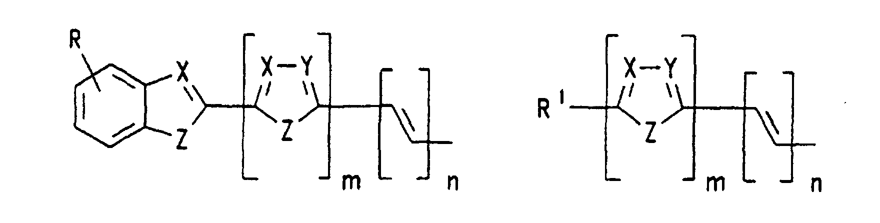 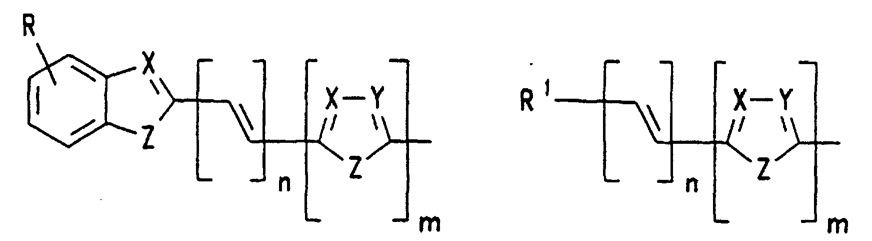 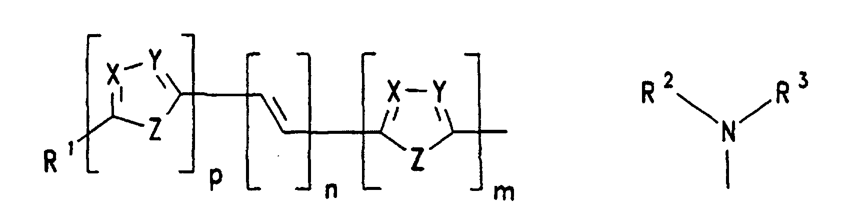
R kann, gleich oder verschieden, die gleichen Bedeutungen wie K, L, M, N haben oder ist -H, eine lineare oder verzweigte Alkyl, Alkoxy oder Estergruppe mit 1 bis 22, vorzugsweise 1 bis 15, besonders bevorzugt 1 bis 12 C-Atomen, -CN, -NR²R³, -Ar oder -O-Ar;
Ar ist Phenyl, Biphenyl, 1-Naphthyl, 2-Naphthyl, 2-Thienyl, 2-Furanyl, 9-Anthryl, wobei jede dieser Gruppen einen oder zwei Reste R tragen kann;
m, n, p sind 0, 1, 2 oder 3;
X, Y sind gleich oder verschieden CR oder Stickstoff;
Z ist -O-, -S-, -NR¹-, -CR¹R⁴-, -CH = CH-, -CH = N-;
R¹, R⁴ können, gleich oder verschieden, die gleichen Bedeutungen wie R haben;
R², R³ sind gleich oder verschieden H, eine lineare oder verzweigte Alkylgruppe mit 1 bis 22 C-Atomen, -Ar, 3-Methylphenyl,
verwendet werden.

4. Detektor nach einem oder mehreren der vorhergehenden Ansprüche, **gekennzeichnet durch** eine lichtabsorbierende Schicht,die ein Halbleitermaterial mit einer Bandlücke von mindestens 3 eV enthält.

5. Detektor gemäß Anspruch 4, **dadurch gekennzeichnet, daß** das Halbleitermaterial ein Metalloxid ist.

6. Detektor nach einem oder mehreren der Ansprüche 4 und 5, **dadurch gekennzeichnet, daß** die Halbleiteroberfläche einen Rauhigkeitsfaktor von > 20 aufweist.

7. Verfahren zur Herstellung eines optoelektronischen Strahlungsdetektors zur Detektion kurzwelliger elektromagnetischer Strahlung nach einem oder mehreren der Ansprüche 4 bis 6, **dadurch gekennzeichnet, daß** man auf einem leitfähigen festen Träger (Elektrode)
a) ein Halbleiterkolloid aufbringt,
b) darauf eine Ladungstransportschicht, enthaltend ein Lochleitermaterial, aufbringt,
c) darauf die Gegenelektrode aufbringt, und auf diese gegebenenfalls
d) eine isolierende Schicht aufbringt.

## Claims

1. An optoelectronic radiation detector for detecting short-wave electromagnetic radiation, which has a charge transport layer comprising a hole conductor material, wherein the hole conductor material used comprises one or more spiro compounds of the formula (I) 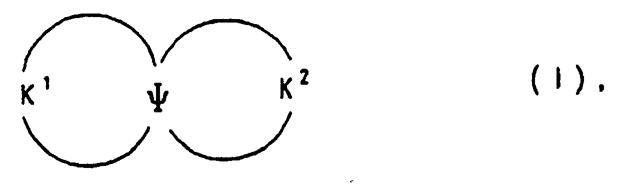 where
ψ is C, Si, Ge or Sn, preferably C, Si, Ge, particularly preferably C, Si and in particular C, and
K¹ and K² are, independently of one another, conjugated systems.

2. A detector as claimed in claim 1, wherein the hole conductor material used comprises one or more 9,9'-spirobifluorene derivatives of the formula (II) 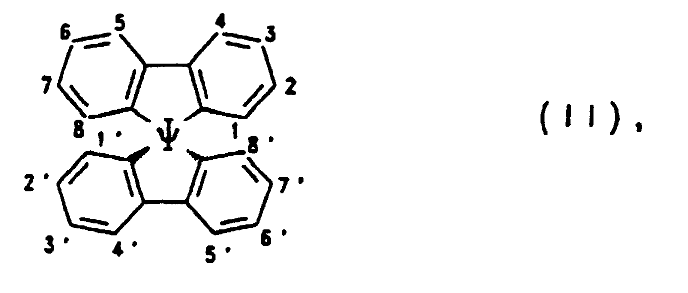 where ψ in formula (II) is as defined in claim 4 and the benzo groups can be, independently of one another, substituted and/or fused.

3. A detector as claimed in claim 2, wherein the hole conductor material used comprises one or more spirobifluorene derivatives of the formula (III), 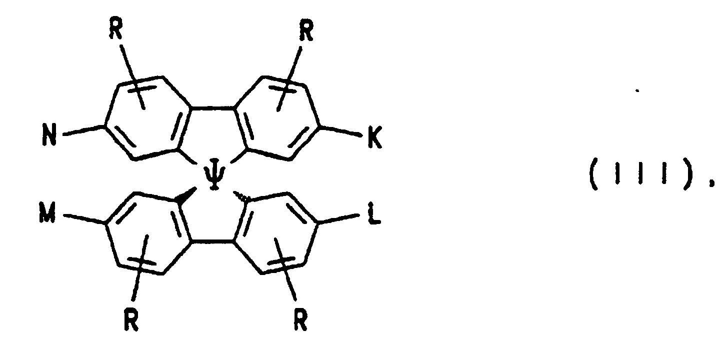 where the symbols and indices have the following meanings :
ψ is C, Si, preferably C,
K, L, M, N are identical or different and are each 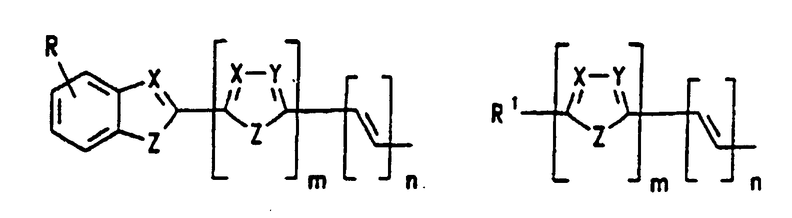 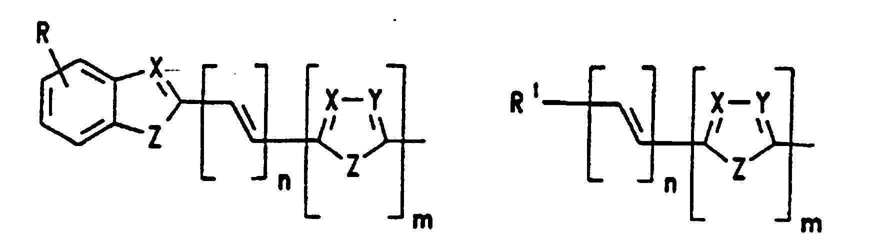 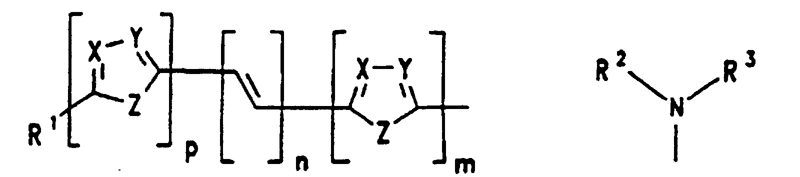
R are identical or different and can be as defined for K, L, M, N or are each -H, a linear or branched alkyl, alkoxy or ester group having from 1 to 22, preferably from 1 to 15, particularly preferably from 1 to 12, carbon atoms, -CN, -NR²R³, -Ar or -O-Ar;
Ar is phenyl, biphenyl, 1-naphthyl, 2-naphthyl, 2-thienyl, 2-furanyl, 9-anthryl, where each of these groups may bear one or more radicals R;
m,n,p are each 0, 1, 2 or 3;
X,Y are identical or different and are each CR or nitrogen;
Z is -O-, -S-, -NR¹-, -CR¹R⁴-_{,} -CH=CH-, -CH=N-;
R¹, R⁴ are identical or different and can be as defined for R;
R², R³ are identical or different and are each H, a linear or branched alkyl group having from 1 to 22 carbon atoms, -Ar, 3-methylphenyl.

4. A detector as claimed in one or more of the preceding claims, which has a light-absorbing layer comprising a semiconductor material having a band gap of at least 3 eV.

5. A detector as claimed in claim 4, wherein the semiconductor material is a metal oxide.

6. A detector as claimed in one or both of claims 4 and 5, wherein the semiconductor surface has a roughness factor of >20.

7. A process for producing an optoelectronic radiation detector for detecting short-wave electromagnetic radiation as claimed in one or more of claims 4 to 6, which comprises
a) applying a semiconductor colloid to a conductive solid support (electrode),
b) applying a charge transport layer comprising a hole conductor material on top of the semiconductor layer,
c) applying the counterelectrode on top of the charge transport layer and, if desired,
d) applying an insulating layer on top of the counterelectrode.

## Revendications

1. Détecteur de rayonnement optoélectronique pour la détection de rayonnement électromagnétique à onde courte présentant une couche de transport de charge, qui renferme un matériau conducteur de trous, **caractérisée en ce qu'**on utilise comme un matériau conducteur de trous un ou plusieurs composés spiranniques de formule (I) 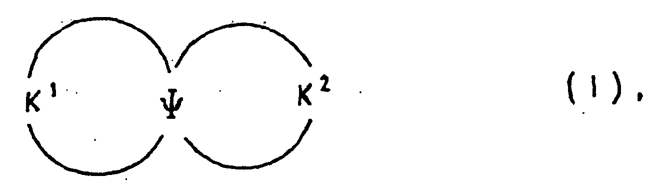 où
Ψ représente un atome de C, Si, Ge ou Sn, de préférence C, Si, Ge, de manière particulièrement préférée C, Si et en particulier C, et
K¹ et K² représentent indépendamment l'un de l'autre des systèmes conjugués.

2. Détecteur selon la revendication 1, **caractérisé en ce qu'**on utilise comme matière de trous un ou plusieurs dérivés du 9,9'-spirobifluorène de formule (II) 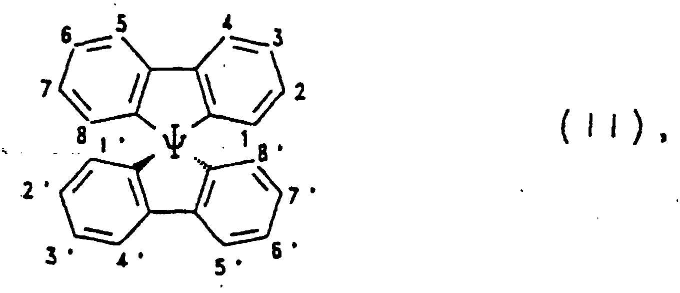 où Ψ à la formule (II) possède les significations données à la revendication 4 et les groupes benzoïques peuvent être, indépendamment l'un de l'autre, substitués et/ou condensés.

3. Détecteur selon la revendication 2, **caractérisé en ce qu'**on utilise comme matière à trous un ou plusieurs dérivés de spirobifluorène de formule (III) 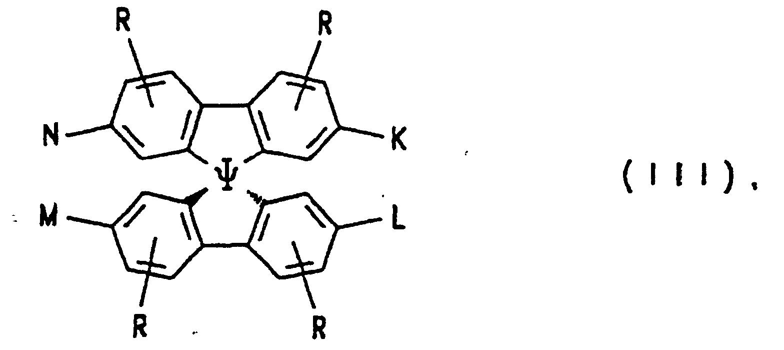 les symboles et les indices ayant les significations suivantes :
Ψ représente un atome de C, Si, de préférence de C,
K, L, M, N sont identiques ou différents 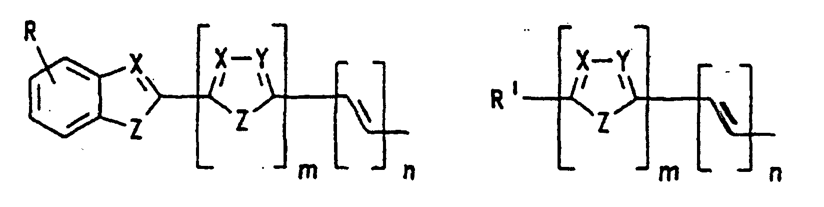 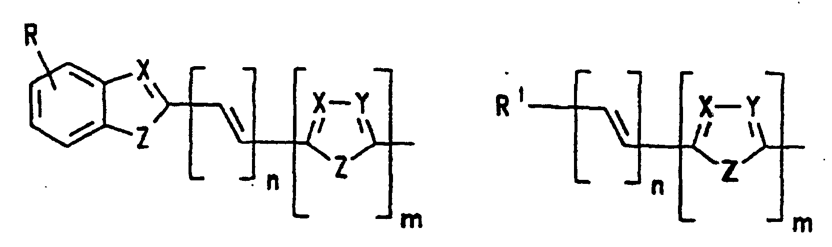 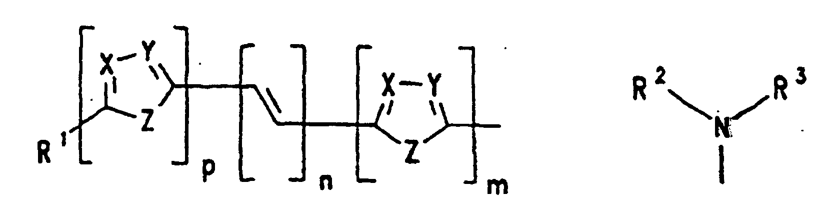
R identiques ou différents, peuvent posséder les mêmes significations que K, L, M, N ou représente -H, un groupe alkoxy, alkyle linéaire ou ramifié, ou ester présentant 1 à 22, de préférence 1 à 15, de manière particulièrement préférée, 1 à 12 atomes de carbone, des groupes -CN, -NR²R³, -AR, -O-Ar ;
Ar représente un groupe phényle, biphényle, 1-naphtyle, 2-naphtyle, 2-thiényle, 2-furanyle, 9-anthryle, chacun de ces groupes pouvant porter un ou deux restes R ;
m, n, p valent 0, 1, 2 ou 3 ;
X, Y sont identiques ou différents et représentent un groupe CR ou un atome d'azote ;
Z représente -O-, -S-, -NR¹-, -CR¹R⁴-, -CH=CH-, -CH=N- ;
R¹, R⁴ identiques ou différents, peuvent posséder les mêmes significations que R ;
R², R³ identiques ou différents représentent un atome d'hydrogène, un groupe alkyle linéaire ou ramifié présentant 1 à 22 atomes de carbone, -Ar, 3-méthylphényle.

4. Détecteur selon une ou plusieurs des revendications précédentes, **caractérisé par** une couche photoabsorbante, qui renferme un matériau semi-conducteur ayant une bande interdite d'au moins 3 eV.

5. Détecteur selon la revendication 4, **caractérisé en ce que** le matériau semi-conducteur est un oxyde métallique.

6. Détecteur selon une ou plusieurs des revendications 4 et 5, **caractérisé en ce que** la surface du semi-conducteur présente un facteur de rugosité >20.

7. Procédé pour la préparation d'un détecteur de rayonnement optoélectronique pour la détection de rayonnement électromagnétique à onde courte selon une ou plusieurs des revendications 4 à 6, **caractérisé en ce qu'**on dépose sur un support conducteur solide (électrode)
a) un colloïde semi-conducteur,
b) on dépose sur celui-ci une couche de transport de charge, renfermant un matériau conducteur de trous,
c) on dépose sur celle-ci une contre-électrode, et on dépose éventuellement sur celle-ci,
d) une couche isolante.
